(19) **Europäisches Patentamt / European Patent Office / Office européen des brevets**

(11) **EP 1 098 557 B1**

(12) **FASCICULE DE BREVET EUROPEEN**

(45) Date de publication et mention
de la délivrance du brevet:
**17.01.2007 Bulletin 2007/03**

(51) Int Cl.:
*H05K 3/00* (2006.01)   *G02B 26/10* (2006.01)
*G03F 7/20* (2006.01)   *H04N 1/192* (2006.01)

(21) Numéro de dépôt: **00402850.2**

(22) Date de dépôt: **16.10.2000**

(54) **Machine d'exposition d'un panneau à un rayonnement laser**

Laser-Belichtungsgerät für Platten

Laser exposure device for plates

(84) Etats contractants désignés:
**AT BE CH CY DE DK ES FI FR GB GR IE IT LI LU MC NL PT SE**

(30) Priorité: **05.11.1999 FR 9913886**

(43) Date de publication de la demande:
**09.05.2001 Bulletin 2001/19**

(73) Titulaire: **AUTOMA-TECH
27100 Val de Reuil (FR)**

(72) Inventeurs:
• **Charbonnier, Serge
27120 Chambray (FR)**

• **Boureau, Damien
76000 Rouen (FR)**

(74) Mandataire: **Dronne, Guy et al
Cabinet Beau de Loménie,
158, rue de l'Université
75340 Paris Cedex 07 (FR)**

(56) Documents cités:
**EP-A- 0 729 265        DE-A- 4 225 946
US-A- 5 795 689**

• **PATENT ABSTRACTS OF JAPAN vol. 1999, no. 09, 30 juillet 1999 (1999-07-30) & JP 11 091164 A (NEC CORP), 6 avril 1999 (1999-04-06)**

## Description

La présente invention a pour objet une machine d'exposition d'un panneau, notamment d'un panneau de circuit imprimé, à un rayonnement laser.

On sait qu'il existe maintenant un certain nombre de techniques utilisant des faisceaux laser pour la réalisation de circuits imprimés et plus précisément pour mettre en oeuvre une des étapes de ce procédé consistant dans la définition des pistes conductrices du circuit imprimé à partir de la couche de métallisation réalisée sur son support isolant. Ces techniques peuvent consister soit à transformer l'état d'une couche de réserve à l'aide du faisceau laser soit à réaliser directement l'ablation de la couche de réserve pour mettre à nu la couche de métallisation soit enfin à ne pas utiliser une couche de réserve et à procéder à l'ablation directe de la couche de métallisation à l'aide du faisceau laser. La présente invention concerne ces trois procédés utilisant un faisceau laser.

Il va de soi que dans une telle technique, chaque point ou pixel de la surface de la zone utile du panneau de circuit imprimé est balayé par le faisceau laser qui est soit à l'état actif, soit à l'état interrompu selon qu'il y a eu lieu d'impressionner ou non le point correspondant. La commande du balayage est associée à des moyens informatiques qui contiennent en mémoire des informations qui permettent de donner, pour chaque pixel, avec ses coordonnées, l'état impressionné ou non à réaliser.

Dans les techniques connues, le balayage est réalisé à l'aide d'un seul faisceau laser qui doit donc balayer l'intégralité de la surface du panneau. Plus précisément, le faisceau laser réalise des balayages successifs selon une des directions du panneau, celui-ci étant déplacé selon l'autre direction.

On comprend que lorsque les circuits imprimés sont de grande dimension, l'opération de balayage à l'aide d'un unique faisceau laser conformément aux techniques connues peut nécessiter un temps important. Il serait donc intéressant de fournir une machine d'exposition dans laquelle le balayage est réalisé simultanément par plusieurs faisceaux laser, chaque faisceau laser balayant une zone du circuit imprimé.

Cependant, on comprend aisément que l'utilisation simultanée de plusieurs faisceaux laser de balayage ne peut résulter d'une simple juxtaposition de dispositifs utilisant chacun un seul faisceau laser de balayage. On comprend, en effet, que pour obtenir la continuité de la réalisation du circuit imprimé d'une zone de balayage à une autre zone de balayage, cela soulève des problèmes spécifiques.

Il faut également souligner que pour obtenir une définition très précise de la géométrie des pistes conductrices, on utilise des faisceaux laser dont le diamètre de l'impact sur les panneaux est de 20 $\mu$m. Cependant, en raison d'une part, de la répartition inégale d'énergie dans ce cercle et d'autre part, de l'imbrication des impacts lors du balayage, tout se passe comme si la surface imprimée du panneau par un impact était un carré de 12,7 par 12,7 $\mu$m. La longueur de 12,7 $\mu$m constitue donc l'unité de définition des différents motifs à réaliser sur le panneau selon les deux directions orthogonales du panneau. Pour conserver la précision des définitions, il est nécessaire que le faisceau laser frappant le panneau de circuit imprimé soit perpendiculaire à celui-ci. En outre, il est nécessaire de disposer pour chaque zone d'une latitude de réglage selon la direction de balayage du faisceau laser pour pouvoir corriger les imperfections de positionnement des différents composants servant à l'élaboration et au pilotage du faisceau laser.

Un objet de la présente invention, est de fournir une machine d'exposition de panneaux à un rayonnement laser utilisant plusieurs faisceaux laser fonctionnant simultanément tout en obtenant la même qualité de définition du circuit imprimé que dans le cas de l'utilisation d'un unique faisceau laser.

Pour atteindre ce but selon l'invention la machine d'exposition d'un panneau à un rayonnement laser, ledit panneau présentant une longueur utile L selon une première direction Y, ladite longueur L étant divisée en N segments successifs de longueur L/N, se caractérise en ce qu'elle comprend :

- un bâti fixe ;
- un support horizontal de panneau pour recevoir ledit panneau ;
- des moyens pour déplacer ledit support par rapport au bâti selon une direction X orthogonale à la direction Y du panneau ;
- des moyens pour élaborer N faisceaux laser principaux ;
- des moyens pour moduler dans le temps chaque faisceau principal ; et
- N blocs optiques fixes par rapport audit bâti, et présentant chacun un axe optique selon une direction sensiblement orthogonale à la direction Y, chaque bloc optique comprenant :

  • des moyens par déviation pour élaborer périodiquement à partir d'un faisceau principal un faisceau continûment dévié et modulé dans le temps, dirigé selon l'axe optique dudit bloc optique.
  • un miroir déflecteur pour diriger ledit faisceau laser dévié selon une direction orthogonale au plan X, Y vers ledit support de panneau, la longueur 11 dudit miroir déflecteur selon la direction orthogonale à l'axe optique dudit bloc, susceptible d'être frappée par ledit faisceau, à chaque période, étant supérieure à UN ;

- lesdits blocs optiques étant répartis en deux ensembles de blocs optiques chaque ensemble comprenant N/2 blocs si N est pair et $\dfrac{N+1}{2}$ et $\dfrac{N-1}{2}$ blocs si N est impair, les blocs d'un même ensemble étant juxtaposés selon la direction Y de telle manière que leurs miroirs déflecteurs soient sensiblement alignés selon la direction Y, la distance selon la direction X entre les miroirs réflecteurs des deux ensembles étant égale à D, la distance selon la direction Y entre les axes optiques de deux blocs optiques juxtaposés d'un même ensemble étant égale à 2UN et la distance selon la direction Y entre l'axe optique d'un bloc d'un ensemble et l'axe optique d'un bloc optique de l'autre ensemble lui étant le plus proche étant égale à UN, par quoi le faisceau laser dévié émis par un bloc optique peut balayer une longueur l1 supérieure à la longueur du segment à balayer effectivement, le faisceau laser dévié pouvant ainsi être commandé pour balayer le segment du panneau de sa première extrémité à sa deuxième extrémité.

Grâce en particulier à la disposition particulière des blocs optiques qui sont disposés selon deux lignes parallèles, les blocs optiques d'un ensemble étant décalés d'un "demi-pas" par rapport à ceux de l'autre ensemble, si l'on appelle "pas" la distance entre les axes otiques de deux blocs juxtaposés d'un même ensemble, il existe une possibilité de recouvrement des zones de balayage des différents blocs optiques. Cette possibilité de recouvrement des zones de balayage permet d'effectuer les corrections inhérentes aux imprécisions de positionnement des différents composants constituant les blocs optiques afin d'atteindre effectivement la précision souhaitée en ce qui concerne les points d'impact successifs des faisceaux laser balayant effectivement chaque zone du panneau.

De préférence, les moyens par déviation de chaque bloc optique comprennent :

- un miroir polygonal rotatif à n facettes pour dévier de façon continue dans un même plan ledit faisceau pendant des périodes fixes successives correspondant auxdites facettes ; et
- des moyens formant objectif pour focaliser et diriger le faisceau dévié successivement par chaque facette du miroir polygonal selon la direction dudit axe optique et dans un même plan contenant la direction Y.

Selon un mode préféré de réalisation, les moyens de modulation comprennent un modulateur acousto-optique qui reçoit le faisceau principal et délivre à sa sortie lesdits faisceaux successifs dans le temps, pendant lesdites périodes fixes.

On comprend que la commande de l'état passant ou non-passant du modulateur acousto-optique permet, outre la modulation du faisceau laser, de synchroniser l'état du modulateur avec la rotation du miroir polygonal et donc avec la position de chacune de ses faces réfléchissantes. Cela permet en particulier d'introduire des corrections, comme on l'expliquera ultérieurement, pour assurer le positionnement précis des extrémités de chaque segment de balayage.

Dans un mode préféré de réalisation, la machine se caractérise en ce que :

- les moyens de déplacement du support de panneau selon la direction X déplacent ledit support de façon continue avec une vitesse constante ; et
- en ce que ladite direction de l'axe optique de chaque bloc optique fait un angle a avec une direction orthogonale à la direction Y pour compenser l'effet du déplacement continu du support selon la direction X.

Dans le cas du déplacement à vitesse constante du support de panneau, ce qui correspond actuellement à la solution optimale, l'introduction de l'angle a permet d'obtenir la continuité des segments balayés simultanément par les faisceaux laser.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées sur lesquelles :

la figure 1 est une vue schématique en élévation de l'ensemble de la machine d'exposition ;
la figure 2 est une vue simplifiée de la partie optique de la machine d'exposition ;
la figure 3 est une vue schématique montrant le balayage d'un panneau par les faisceaux laser ;
la figure 4 est une vue de dessus de l'ensemble des blocs optiques de la machine d'exposition ;
la figure 5 est une vue de dessus d'un bloc optique ;
la figure 6 est une vue de côté du même bloc optique ; et
la figure 7 illustre les possibilités de réglage des zones balayées par les différents faisceaux laser.

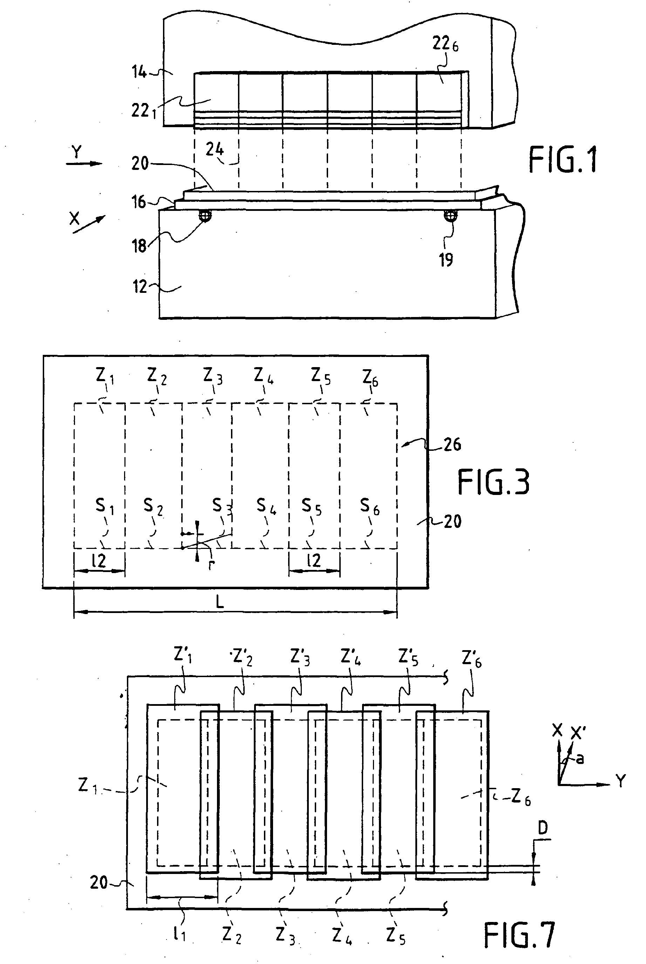

En se référant tout d'abord à la figure 1, on va décrire l'ensemble de la machine d'exposition. Celle-ci comprend un bâti comportant une partie inférieure 12 et une partie supérieure 14, ce bâti étant bien sûr fixe. La partie inférieure 12 du bâti supporte un plateau mobile 16 pour recevoir un panneau 20. Le plateau 16 peut se déplacer selon une direction X, c'est-à-dire selon une direction orthogonale au plan de la figure. Pour cela, on a représenté schématiquement des systèmes de vis à billes 18, 19 entraînés par des moteurs. Le plateau support 16 est destiné à recevoir le panneau de circuit imprimé 20 qui doit être soumis au faisceau laser pour définir les pistes conductrices à réaliser sur le panneau de circuit imprimé. La partie supérieure 14 du bâti supporte des blocs optiques que l'on a représenté schématiquement par des rectangles $22_1$ à $22_6$. Chaque bloc optique

22 délivre un faisceau laser à sa sortie, ce faisceau laser ayant une direction orthogonale au plan du panneau 20, c'est-à-dire une direction verticale. On a représenté de façon symbolique par les pointillés 24 les zones de balayage de chaque faisceau laser, le balayage étant réalisé selon la direction Y orthogonale à la direction X.

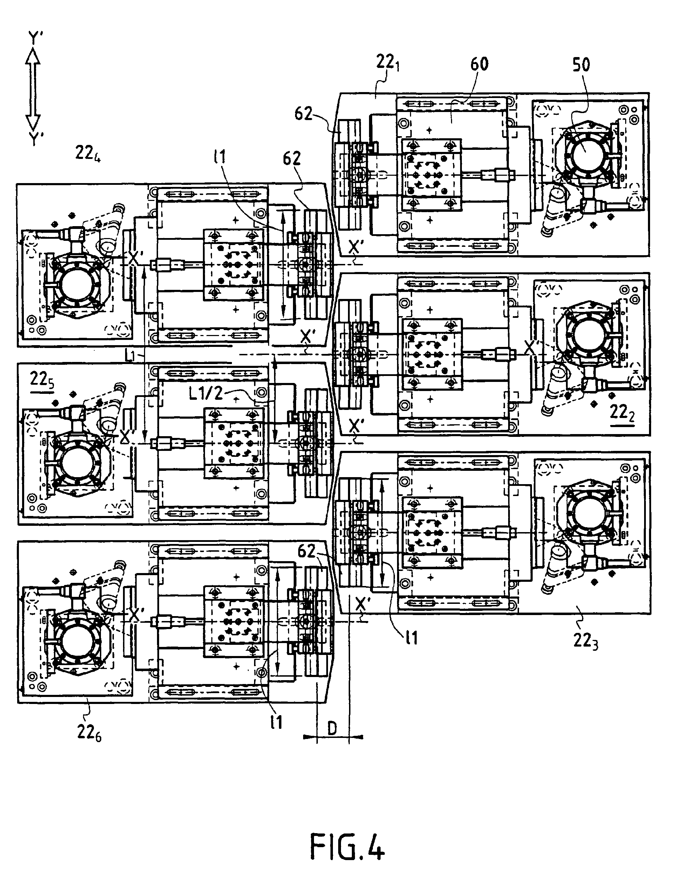

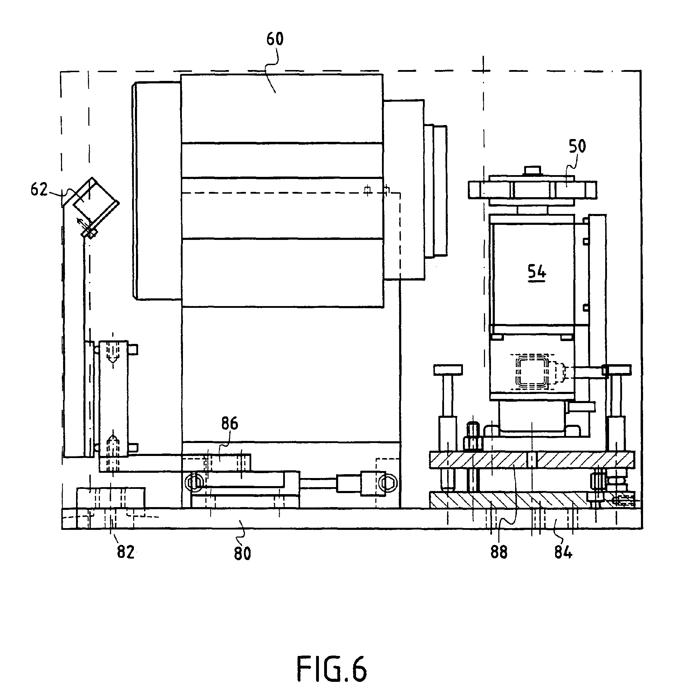

Dans la machine décrite à titre d'exemple, en relation avec la figure 3, le balayage de la partie utile 26 du panneau 20 est réalisé simultanément par six faisceaux laser qui balayent chacun selon la direction Y des zones $Z_1$, $Z_2$, $Z_3$, $Z_4$, $Z_5$, $Z_6$ de la partie utile du panneau. Par balayage, il faut entendre le déplacement du faisceau laser de façon continue selon la direction Y. L'unité de déplacement est le pixel, c'est-à-dire le plus petit motif réalisable par le faisceau laser. Dans l'exemple particulier, le pixel est un carré de côté égal à 12,7 $\mu$m, comme on l'a déjà indiqué. En réalité, durant le balayage du segment S, on a des sous-segments correspondant à un impact effectif du faisceau laser et des sous-segments où le faisceau laser est interrompu. L'"unité" de largeur de ces sous-segments est bien sûr le pixel. Le balayage dans la direction X orthogonale à la direction Y est obtenu comme on l'a déjà expliqué par le déplacement de ce panneau selon la direction X. Si l'on appelle L la longueur selon la direction Y de la partie utile 26 du panneau, chaque faisceau laser doit donc balayer un segment S1, S2, etc..., de longueur 12, 12 étant égale à UN. Le nombre N de faisceaux pourrait bien sûr être différent de six.

On voit que, pour assurer la continuité du motif à réaliser d'une zone à la zone adjacente, il est nécessaire que le dernier impact du balayage, par exemple du segment S1, soit distant d'un pixel du premier point d'impact du balayage du segment S2.

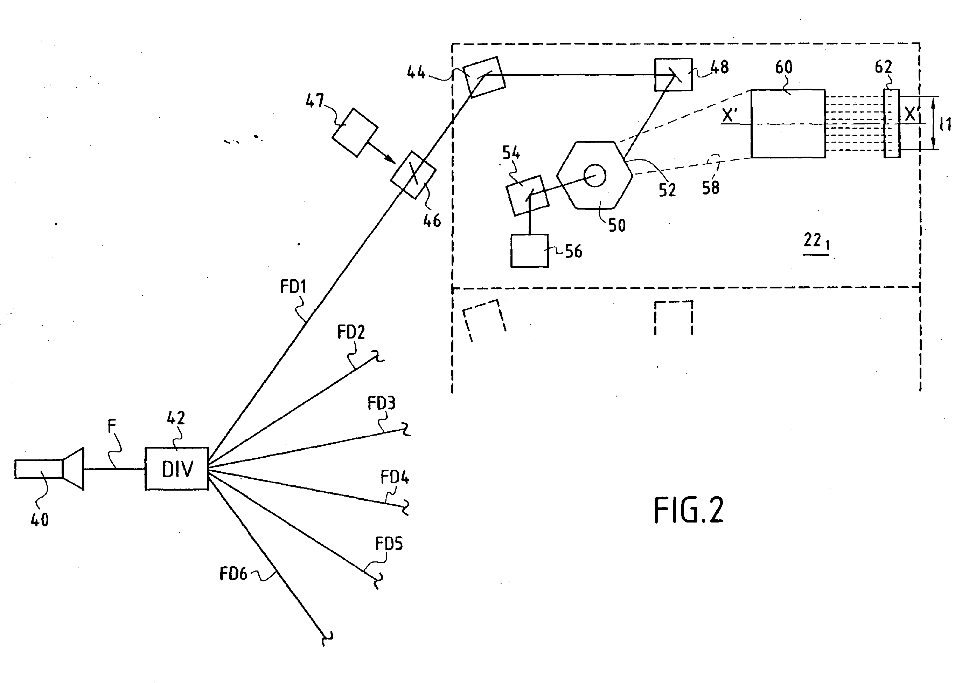

En se référant maintenant à la figure 2, on va décrire les éléments essentiels de la partie optique de la machine d'exposition permettant de réaliser le balayage simultané du panneau par les six faisceaux laser dans le cas particulier considéré.

L'ensemble optique comprend un laser 40 qui est de préférence du type à argon délivrant une puissance de 7 W dans le cas où la machine a pour fonction de modifier l'état de la couche de réserve. Le faisceau F délivré par le laser 40 est appliqué à l'entrée d'un diviseur de faisceau 42 qui divise ce faisceau en 6 faisceaux divisés FD1, FD2, FD3, FD4, FD5, FD6. De préférence, tous les faisceaux divisés FD ont des puissances du même ordre de grandeur et comportent un nombre limité de longueurs d'onde qui sont de plus très proches les unes des autres.

Chaque faisceau divisé FD est appliqué à l'entrée d'un modulateur acousto-optique 46 associé à un circuit de commande 47. Comme cela est bien connu, le modulateur peut prendre un état passant ou un état non-passant interrompant la transmission du faisceau laser. Chaque faisceau sortant d'un modulateur est appliqué à l'entrée d'un bloc optique 22. Le bloc optique comprend une optique d'entrée 44 et un système optique 48 destiné à diriger le faisceau vers un miroir polygonal rotatif 50.

Comme cela est bien connu, le miroir polygonal 50 est constitué par une pluralité de faces réfléchissantes 52. Dans le cas particulier de la figure 2, il y a six faces réfléchissantes. Dans d'autres modes de réalisation, le miroir pourrait comporter dix faces. Le miroir 50 est entraîné en rotation par un moteur 54 associé à un circuit de commande 56 et à des capteurs de position.

Comme cela est bien connu, le faisceau laser sortant du système optique 48 frappe une facette 52 du miroir polygonal selon une incidence qui varie de façon continue en fonction de la rotation du miroir. On obtient ainsi une déviation continue du faisceau réfléchi par la face. On a représenté symboliquement par 58 l'angle dans lequel le faisceau réfléchi est dévié par la rotation de la facette du miroir polygonal. La déviation du faisceau par une facette du miroir rotatif correspond au balayage d'un segment S du panneau. La définition du début du balayage et de la fin du balayage par le faisceau laser est réalisé par la synchronisation de la commande de l'état passant ou non-passant du modulateur avec la rotation du miroir polygonal. Le modulateur est bien sûr non-passant durant les laps de temps où le faisceau laser incident aurait dû passer d'une facette du miroir à la suivante. Chaque facette définit ainsi une période de balayage correspondant à un segment. Le faisceau est appliqué à l'entrée d'un objectif 60. L'objectif 60 a pour double fonction de focaliser le faisceau laser pour que son diamètre soit, dans le cas particulier considéré, égal à 20 $\mu$m, c'est-à-dire supérieur au pixel et de diriger le faisceau laser selon la direction X'X' de l'axe optique du bloc optique.

Le bloc optique 22 comprend enfin, pour ces éléments essentiels, un miroir déflecteur 62 qui est orthogonal à l'axe optique X'-X' du bloc optique. Le miroir 62 qui réfléchit le faisceau laser dévié selon une direction verticale, c'est-à-dire vers le support de panneau 16 et donc vers le panneau lui-même et orthogonalement à celui-ci. La déviation du faisceau est telle que le faisceau dévié frappe le miroir 62 en des points qui s'étendent sur une longueur l1 centrée sur l'axe optique X'X'. Les composants optiques sont réalisés de telle manière que la longueur l1 soit supérieure à la longueur 12 correspondant à la zone de balayage Z du panneau associé au faisceau laser considéré.

En se référant maintenant à la figure 4, on va décrire la disposition relative des blocs optiques 22 fixés sur la partie supérieure 14 du bâti de la machine. Dans l'exemple particulier considéré, il y a six faisceaux laser et donc six blocs optiques 22. Ces blocs optiques sont répartis en deux ensembles de trois blocs juxtaposés selon la direction Y'-Y' orthogonale à la direction X'-X' des axes optiques des blocs. Les blocs optiques d'un même ensemble sont distants les uns des autres d'une distance égale à $L_1$, $L_1$ étant égal à 2L/N. Les blocs optiques des deux ensembles respectivement $22_1$ à $22_3$ et $22_4$ à $22_6$ sont imbriqués, c'est-à-dire que la distance entre l'axe optique d'un bloc d'un premier ensemble à l'axe optique d'un bloc du deuxième ensemble le plus proche est égale à $L_1/2$, c'est-à-dire UN. Sur cette figure, on a fait également apparaître la longueur $l_1$ correspondant à la plage de balayage possible par le faisceau dévié par une même face du miroir rotatif. On comprend que lorsque l'on passe d'un bloc optique d'un ensemble au bloc optique suivant de l'autre ensemble, il existe un recouvrement entre les longueurs l1 de balayage par les faisceaux laser correspondants. De même, compte tenu de la géométrie des blocs optiques, il existe une distance D entre les points d'impact des faisceaux sur les miroirs de sortie 62 des blocs optiques, ces miroirs appartenant à des blocs faisant respectivement partie d'ensembles différents.

En se référant maintenant à la figure 7, on va décrire les possibilités de réglage des six faisceaux laser obtenus grâce aux dispositions de l'invention. Sur cette figure, on a fait apparaître en pointillés les zones $Z_1$ à $Z_6$ qui doivent être effectivement balayées par chaque faisceau laser, ces zones se juxtaposant rigoureusement selon la direction Y du panneau. En traits pleins, on représenté les zones $Z'_1$ à $Z'_6$ susceptibles d'être balayées respectivement par les faisceaux laser. On comprend que ces zones présentent la largeur l1 qui est supérieure à 12 et on comprend également qu'entre la zone $Z'_1$ susceptible d'être balayée par le bloc optique $22_1$ du premier ensemble de blocs optiques et la zone $Z'_2$ susceptible d'être balayée par le bloc optique $22_4$, il existe un décalage D selon la direction X du panneau.

Il est ainsi possible, par une commande convenable du modulateur acousto-optique 46 de chaque bloc optique, de définir pour chaque facette 52 du miroir polygonal l'instant de début de balayage d'une zone Zi de telle manière qu'elle corresponde effectivement à cette zone malgré les imperfections de positionnement des différents systèmes optiques. On comprend également que pour obtenir effectivement le balayage des zones Z selon la direction X les modulateurs acousto-optiques 46 des blocs optiques du premier ensemble seront commandés après les modulateurs optiques des blocs optiques du deuxième ensemble pour tenir compte du décalage D selon la direction X.

On comprend ainsi que grâce à l'invention, il est possible d'obtenir effectivement un balayage continu de l'ensemble de la zone utile du panneau bien que ce balayage soit réalisé simultanément par six faisceaux laser distincts.

De préférence, le déplacement du panneau selon la direction X par les systèmes à vis 18 et 19 se fait de façon continue. Il en résulterait donc pour chaque balayage d'une zone par un faisceau laser que ce balayage ne serait pas réalisé selon la direction Y mais selon une direction Y' faisant un angle a avec cette direction du fait de la composition des déplacements selon les deux directions. La tangente de l'angle a correspond au rapport entre la distance selon la direction X référencée r d'un balayage au balayage suivant et la longueur 12 de balayage d'une zone. Cette distance r correspond à la dimension de l'impact du faisceau laser sur le panneau qui est de l'ordre de 12,7 $\mu$m. La tangente de l'angle a correspond donc à r/l2. Ces angle est donc faible. Pour éviter ce phénomène, les axes optiques X'X' de chaque bloc optique ne sont pas dirigés selon la direction X du bâti mais font l'angle a avec cette direction. Bien entendu, l'angle a est dans le sens opposé pour les blocs optiques du premier ensemble et les blocs optiques du deuxième ensemble.

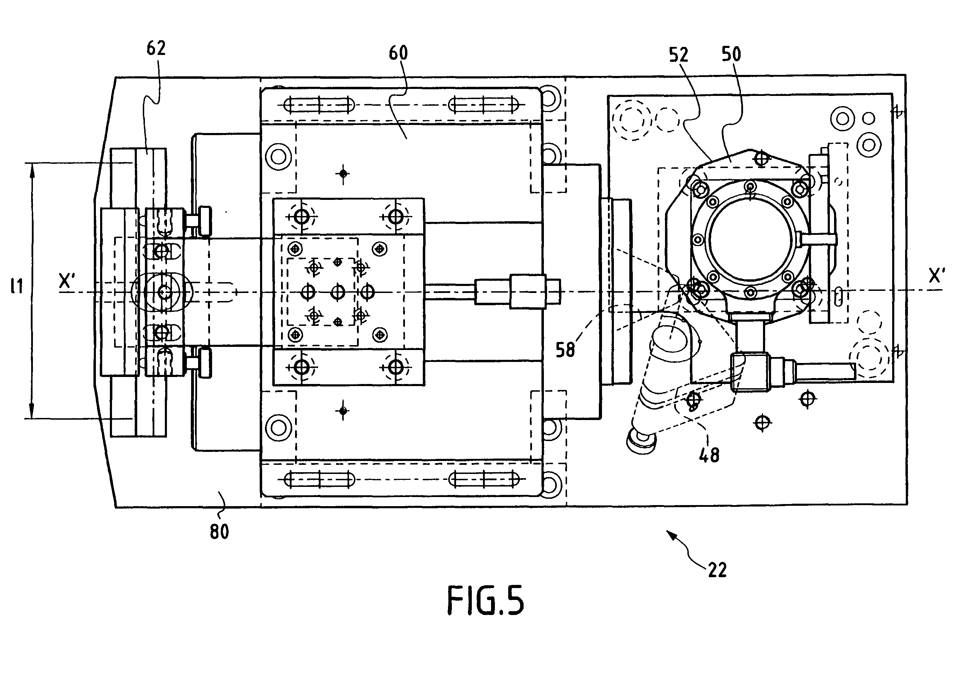

Sur les figures 5 et 6, on a représenté un mode de réalisation d'un bloc optique 22. Dans le mode de réalisation représenté sur les figures 4 à 6, le modulateur acousto-optique n'est pas monté sur le socle du bloc optique. Les six modulateurs sont montés sur une platine séparée sur laquelle est également fixé le diviseur du faisceau. Cette solution permet d'assurer un positionnement rigoureux des modulateurs acousto-optiques par rapport aux faisceaux laser divisés. Le bloc optique 22 comprend un socle 80 qui est fixé sur la partie supérieure 14 du bâti de la machine par des organes de réglage mécanique tels que 82 et 84. Ces organes permettent de rattraper des tolérances de montage et d'introduire l'angle a que doit faire l'axe optique X'X' du bloc optique avec la direction X du bâti. Ces moyens de réglage permettent également de corriger une erreur dans la direction de déplacement X du support par rapport à la direction Y du panneau. Dans ce cas, l'angle introduit entre la direction orthogonale à la direction Y du panneau et l'axe optique XX' est égale à b et tient compte des deux corrections. Le miroir déflecteur 62 est monté sur le socle 80 par l'intermédiaire d'une platine 86 qui permet de régler avec une grande précision la position du miroir 62 par rapport au socle. De même, le miroir polygonal rotatif 50 avec son moteur 54 est fixé sur une platine 88 réglable par rapport au socle 80.

Sur ces figures, on a également fait apparaître l'objectif 60 et le miroir 48 déviant le faisceau laser vers le miroir rotatif 50.

**Revendications**

1. Machine d'exposition d'un panneau à un rayonnement laser, ledit panneau présentant une longueur utile L selon une première direction Y, ladite longueur L étant divisée en N segments successifs de longueur L//N, ladite machine **se caractérisant en ce qu'**elle comprend :

   - un bâti fixe ;
   - un support horizontal de panneau pour recevoir ledit panneau ;
   - des moyens pour déplacer ledit support par rapport au bâti selon une direction X orthogonale à la direction Y du panneau ;
   - des moyens pour élaborer N faisceaux laser principaux ;
   - des moyens pour moduler dans le temps chaque faisceau principal ; et

- N blocs optiques fixes par rapport audit bâti présentant un axe optique selon une direction sensiblement orthogonale à la direction Y, chaque bloc optique comprenant :

> • des moyens par déviation pour élaborer périodiquement à partir d'un faisceau principal un faisceau continûment dévié et modulé dans le temps, dirigé selon l'axe optique dudit bloc optique.
> • un miroir déflecteur pour diriger ledit faisceau laser dévié selon une direction orthogonale au plan X, Y vers ledit support de panneau, la longueur 11 dudit miroir déflecteur selon la direction orthogonale à l'axe optique dudit bloc, susceptible d'être frappée par ledit faisceau, à chaque période, étant supérieure à UN ;

- lesdits blocs optiques étant répartis en deux ensembles de blocs optiques chaque ensemble comprenant N/2 blocs si N est pair et $\dfrac{N+1}{2}$ et $\dfrac{N-1}{2}$ blocs si N est impair, les blocs d'un même ensemble étant juxtaposés selon la direction Y de telle manière que leurs miroirs déflecteurs soient sensiblement alignés selon la direction Y, la distance selon la direction X entre les miroirs déflecteurs des deux ensembles étant égale à D, la distance selon la direction Y entre les axes optiques de deux blocs optiques juxtaposés d'un même ensemble étant égale à 2UN et la distance selon la direction Y entre l'axe optique d'un bloc d'un ensemble et l'axe optique d'un bloc optique de l'autre ensemble lui étant le plus proche étant égale à UN, par quoi le faisceau laser dévié émis par un bloc optique peut balayer une longueur l1 supérieure à la longueur du segment à balayer effectivement, le faisceau laser dévié pouvant ainsi être commandé pour balayer le segment du panneau de sa première extrémité à sa deuxième extrémité.

2. Machine selon la revendication 1, **caractérisée en ce que** les moyens par déviation de chaque bloc optique comprennent :

> - un miroir polygonal rotatif à n facettes pour dévier de façon continue dans un même plan ledit faisceau pendant des périodes fixes successives correspondant auxdites facettes ; et
> - des moyens formant objectif pour focaliser et diriger le faisceau dévié successivement par chaque facette du miroir polygonal selon la direction dudit axe optique et dans un même plan contenant la direction Y.

3. Machine selon la revendication 2, **caractérisée en ce que** les moyens de modulation dans le temps comprennent un modulateur acousto-optique recevant ledit faisceau principal et délivrant à sa sortie ledit faisceau modulé dans le temps.

4. Machine selon la revendication 3, **caractérisée en ce que** ledit modulateur acousto-optique comprend des moyens de commande pour que, pour chaque période de balayage, le premier point d'impact du faisceau laser vertical sur le panneau coïncide avec l'origine du segment correspondant au bloc optique considéré.

5. Machine selon l'une quelconque des revendications 1 à 4, **caractérisée en ce que** :

> - les moyens de déplacement du support de panneau selon la direction X déplacent ledit support de façon continue avec une vitesse constante ; et
> - ladite direction de l'axe optique de chaque bloc optique fait un angle a avec une direction orthogonale à la direction Y pour compenser l'effet du déplacement continu du support selon la direction X.

6. Machine selon l'une quelconque des revendications 1 à 4, **caractérisée en ce que** :

> - les moyens de déplacement du support de panneau selon la direction X déplacent ledit support de façon continue avec une vitesse constante ; et
> - ladite direction de l'axe optique de chaque bloc optique fait un angle b avec une direction orthogonale à la direction Y pour compenser l'effet du déplacement continu dudit support selon la direction X et pour compenser l'erreur de perpendicularité de la direction de déplacement X avec la direction Y.

**Claims**

1. A machine for exposing a panel to laser radiation, said panel having a working length L in a first direction Y, said length L being divided into N successive segments of length L/N, said machine being **characterised in that** it comprises:

> - a fixed structure;
> - a horizontal panel support for receiving said panel;
> - displacement means for moving said support relative to the structure in a direction X that is orthogonal to the Y direction of the panel;

- means for generating N main laser beams;

- modulator means for modulating each main laser beam in time; and

- N optical units that are fixed relative to said structure each having an optical axis in a direction that is substantially orthogonal to the Y direction, each optical unit comprising:

> • deflector means for periodically converting one of the main beams into a beam that is continuously deflected and that is modulated in time, said beam being directed along the optical axis of said optical unit; and
> • a deflector mirror for directing said deflected laser beam in a direction orthogonal to the X,Y plane towards said panel support, the length $l_1$ of said deflector mirror in the direction orthogonal to the optical axis of said unit and suitable for being struck by said beam during each period being greater than L/N;

- said optical units being organized as two sets of optical units with each set having N/2 units if N is even and $\frac{N+1}{2}$ and $\frac{N-1}{2}$ units if N is odd, the units if N is odd, the units within each set being juxtaposed in the Y direction in such a manner that their deflector mirrors are substantially in alignment along the Y direction, the distance in the X direction between the deflector mirrors of the two sets being equal to D, the distance in the Y direction between the optical axes of two juxtaposed optical units in the same set being equal to 2L/N and the distance in the Y direction between the optical axis of a unit in one set and the optical axis of the nearest optical unit in the other set being equal to L/N, whereby the deflected laser beam from an optical unit is capable of scanning over a length $l_1$ that is longer than the length of the segment that needs to be scanned, the deflected laser beam thus being capable of being controlled to scan the panel segment from its first end to its second end.

2. A machine according to claim 1, **characterised in that** the deflector means of each optical unit comprise:

- a rotary polygonal mirror having $n$ facets for continuously deflecting said laser beam in the same plane during successive fixed periods corresponding to said facets; and

- objective lens means to focus and direct the beam as deflected successively by each facet of the polygonal mirror along the direction of said optical axis and in a common plane containing the Y direction.

3. A machine according to claim 2, **characterised in that** the modulator means in time comprise an acousto-optical modulator receiving said main beam and delivering said time modulated beam at its outlet.

4. A machine according to claim 3, **characterised in that** said acousto-optical modulator comprises control means for ensuring that during each scan period the first point of impact of the vertical laser beam on the panel coincides with the origin of the segment corresponding to the optical unit in question.

5. A machine according to any one of claims 1 to 4, **characterised in that**:

- the displacement means for moving the panel support in the X direction move said support continuously at a constant speed; and

- said direction of the optical axis of each optical unit is at an angle $a$ with a direction orthogonal to the Y direction so as to compensate for the effect of the continuous displacement of the support in the X direction.

6. A machine according to any one of claims 1 to 4, **characterised in that**:

- the displacement means for moving the panel support in the X direction move said support continuously at a constant speed; and

- said direction of the optical axis of each optical unit is at an angle $b$ with a direction orthogonal to the Y direction in order to compensate for the effect of the continuous displacement of said support in the X direction and to compensate for the error in perpendicularity between the travel direction X and the Y direction.

**Patentansprüche**

1. Laser-Belichtungsgerät für eine Platte, welche eine Nutzlänge L in einer ersten Richtung Y aufweist, wobei die Länge L in N fortlaufende Segmente aufgeteilt ist mit einer Länge L/N, wobei das Gerät **dadurch gekennzeichnet ist, daß** es folgendes umfaßt:

> - ein festes Gestell,
> - einen horizontalen Plattenhalter zur Aufnahme der Platte,
> - Mittel zum Verschieben des Halters bezogen auf das Gestell in einer zur Richtung Y der Platte orthogonalen Richtung X,

- Mittel zur Erstellung von N Hauptlaserstrahlen und

- N feste optische Blöcke bezogen auf das Gestell mit einer optischen Achse gemäß einer Richtung, welche im wesentlichen orthogonal zur Richtung Y ist, wobei jeder optische Block umfaßt:

- durch Ablenkung wirkende Mittel, um anhand eines Hauptstrahls periodisch einen kontinuierlich abgeleiteten und zeitlich modulierten Strahl zu erstellen, der entlang der optischen Achse des optischen Blocks gelenkt wird,

- einen Ablenkspiegel, um den Laserstrahl, der in einer orthogonalen Richtung zur Fläche X, Y zum Plattenhalter abgelenkt wird, zu lenken, wobei die Länge l1 des Ablenkspiegels in der orthogonalen Richtung zur optischen Achse des Blocks, die vom Strahl in jeder Periode getroffen werden kann, größer als L/N ist,

- wobei die optischen Blöcke in zwei Einheiten optischer Blöcke verteilt sind, wobei jede Einheit N/2 Blöcke umfaßt, wenn N gerade ist und $\dfrac{N+1}{2}$ und $\dfrac{N-1}{2}$ Blöcke, wenn N ungerade ist,

- wobei die Blöcke einer gleichen Einheit in Richtung Y in einer Weise nebeneinanderliegen, daß ihre Ablenkspiegel im wesentlichen in Richtung Y ausgerichtet sind, wobei der Abstand in Richtung X zwischen dem Ablenkspiegel der zwei Einheiten gleich D ist, wobei der Abstand in Richtung Y zwischen den optischen Achsen von zwei nebeneinanderliegenden optischen Blöcken einer gleichen Einheit gleich 2L/N ist und der Abstand in Richtung Y zwischen der optischen Achse eines Blocks einer Einheit und der optischen Achse eines optischen Blocks der anderen Einheit, die ihm am nächsten liegt, gleich L/N ist, wobei der abgelenkte Laserstrahl, der durch einen optischen Block abgestrahlt wird, eine Länge l1 abtasten kann, die größer ist als die Länge des effektiv abzutastenden Segments, so daß der abgelenkte Laserstrahl gesteuert werden kann, um das Segment der Platte von seinem ersten Ende bis zu seinem zweiten Ende abzutasten.

2. Gerät nach Anspruch 1, **dadurch gekennzeichnet, daß** die durch Ablenkung wirkenden Mittel jedes optischen Blocks umfassen:

- einen drehbaren Polygonalspiegel mit n Facetten, um den Strahl während der fortlaufenden festen Perioden, die den Facetten entsprechen, auf kontinuierliche Weise in einer gleichen Ebene abzulenken, und

- ein Objektiv bildende Mittel zur Fokussierung und Lenkung des Strahls, der fortlaufend durch jede Facette des Polygonalspiegels in Richtung der optischen Achse und in einer gleichen Ebene, welche die Richtung Y einschließt, abgelenkt wird.

3. Gerät nach Anspruch 2, **dadurch gekennzeichnet, daß** die Mittel zur zeitlichen Modulation einen akustooptischen Modulator umfassen, der den Hauptstrahl empfängt und an seinem Ausgang den zeitlich modulierten Strahl bereitstellt.

4. Gerät nach Anspruch 3, **dadurch gekennzeichnet, daß** der akusto-optische Modulator Steuermittel umfaßt, damit für jede Abtastperiode die Auftreffstelle des vertikalen Laserstrahls auf der Platte mit dem Ursprung des Segments, das dem betrachteten optischen Block entspricht, übereinstimmt.

5. Gerät nach einem beliebigen der Ansprüche 1 bis 4, **dadurch gekennzeichnet, daß**:

- die Mittel zum Verschieben des Plattenhalters in Richtung X den Halter auf kontinuierliche Weise mit eine konstanten Geschwindigkeit verschieben, und

- die Richtung der optischen Achse jedes Blocks einen Winkel a mit einer orthogonalen Richtung Y zum Ausgleich der Wirkung der kontinuierlichen Verschiebung des Halters in Richtung X bildet.

6. Gerät nach einem der beliebigen Ansprüche 1 bis 4, **dadurch gekennzeichnet, daß**:

- die Mittel zur Verschiebung des Plattenhalters gemäß der Richtung X den Halter auf kontinuierliche Weise mit einer konstanten Geschwindigkeit verschieben und

- die Richtung der optischen Achse jedes optischen Blocks einen Winkel b mit einer Richtung, die orthogonal zur Richtung Y ist, bildet, um die Wirkung der kontinuierlichen Verschiebung des Halters in Richtung X auszugleichen und um den Senkrechtrichtungsfehler der Verschiebungsrichtung X mit der Richtung Y auszugleichen.

FIG.1

FIG.3

FIG.7

FIG.2

EP 1 098 557 B1

FIG.4

FIG.6

FIG.5

EP 1 098 557 B1